# EUROPÄISCHE PATENTSCHRIFT

(11) **EP 0 611 274 B1**
(45) Veröffentlichungstag und Bekanntmachung des Hinweises auf die Patenterteilung: **02.12.1998**
(21) Anmeldenummer: 94890006.3
(22) Anmeldetag: 13.01.1994
(51) Int. Cl.: H01L 21/00

(54) **Träger für scheibenförmige Gegenstände**
Holder for disc-like articles
Support pour objets en forme de disque

(30) Priorität: 08.02.1993 AT 220/93
(43) Veröffentlichungstag der Anmeldung: 17.08.1994
(73) Patentinhaber: SEZ Semiconductor-Equipment Zubehör für die Halbleiterfertigung AG, 9500 Villach (AT)
(72) Erfinder: Sumnitsch, Franz, A-9020 Klagenfurt (Kärnten) (AT)
(74) Vertreter: Beer, Manfred, Dipl.-Ing.

(56) Entgegenhaltungen:
- EP-A- 0 242 065
- US-A- 4 788 994

## Beschreibung

Die Erfindung betrifft einen Träger mit den im einleitenden Teil des unabhängigen Anspruch 1 genannten Merkmalen.

Ein derartiger Träger ist aus der US-A-4 903 717 (= EP-A-0 444 714) bekannt. Bei diesem bekannten Träger ist der Antrieb für das Verdrehen der Nocken teilweise in einem Raum im Träger aufgenommen, durch den das Druckgas zur Düse strömt. Dies hat sich deswegen als nachteilig erwiesen, weil Abrieb, der entsteht, wenn die Nocken verdreht werden, vom Druckgas durch die Düse nach außen geblasen wird und sich am scheibenförmigen Gegenstand, der am Träger gehalten ist, niederschlägt. Ein weiterer Nachteil besteht darin, daß die Strömung des Gases durch den Träger zur Düse vom Antrieb für das Verdrehen der Nocken beeinträchtigt wird.

Der Erfindung liegt die Aufgabe zugrunde, einen Träger der eingangs genannten Gattung anzugeben, der die genannten Nachteile nicht aufweist und dennoch verstellbare Anschläge für den zu behandelnden Gegenstand aufweist.

Erfindungsgemäß wird dies bei einem Träger der oben genannten Gattung durch die im kennzeichnenden Teil des Anspruches 1 genannten Merkmale erreicht.

Durch die erfindungsgemäß vorgeschlagene Trennung des Weges der Gasströmung von dem Raum, der den mechanischen Antrieb für das Verstellen der Nocken zum seitlichen Halten und Zentrieren des scheibenförmigen Gegenstandes aufnimmt, treten die oben erwähnten Nachteile nicht auf und es können beide Räume für den Zweck, dem sie jeweils dienen (Aufnahme des Antriebes für das Verstellen der Nocken einerseits und Gasströmung anderseits) optimal ausgelegt und dimensioniert werden.

Eine Ausführungsform, die sich ohne Beeinträchtigung der Trennung der beiden Räume des erfindungsgemäßen Trägers verwirklichen läßt und bei der der für das Verstellen der Nocken vorgesehene Zahnkranz genau und leichtgänig geführt ist, ist Gegenstand von Anspruch 8.

Mit dem Vorteil einer einfach ausgebildeten Konstruktion, welche auch die Abdichtung der beiden Räume im erfindungsgemäßen Träger sicherstellt, kann der Träger gemäß der Erfindung wie in Anspruch 11 gekennzeichnet ausgebildet sein.

Weitere Einzelheiten und Merkmale der Erfindung ergeben sich aus der nachstehenden Beschreibung des in der Zeichnung teilweise schematisch gezeigten Ausführungsbeispieles eines Trägers der Erfindung. Es zeigt:

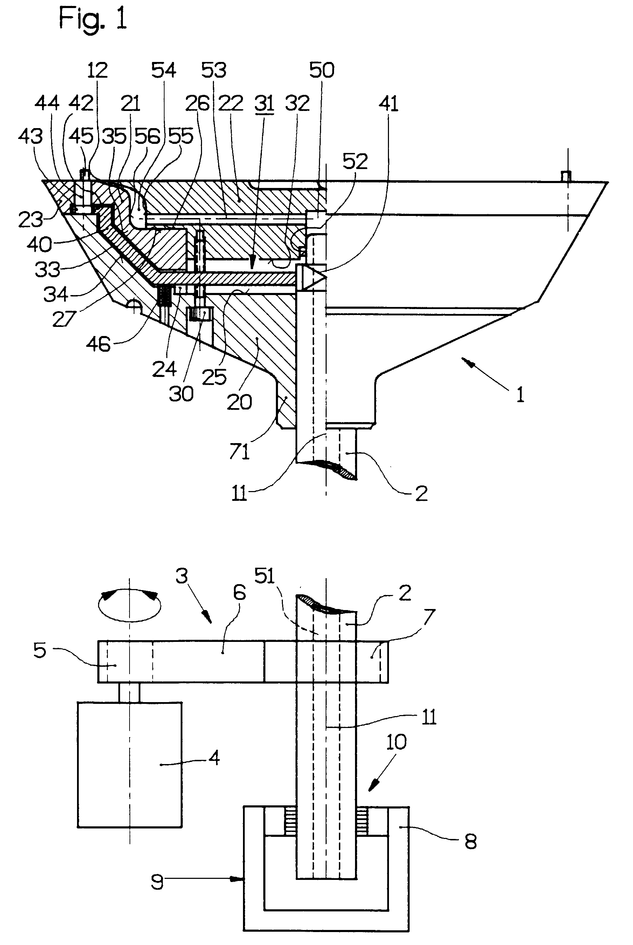

Fig. 1 einen Träger im Axialschnitt,
Fig. 2 eine Bremse schematisch in Draufsicht,
Fig. 3 die Bremse aus Fig. 2 im Schnitt und
Fig. 4 eine andere Ausführungsform einer Bremse.

Ein Träger 1, der für das Halten eines scheibenförmigen Gegenstandes bestimmt ist, insbesondere während dieser mit einer Behandlungsflüssigkeit behandelt wird (beispielsweise werden Siliziumscheiben geätzt), ist auf einer hohl ausgebildeten Trage-Welle 2 montiert und kann über diese in Drehung um seine Achse 11 versetzt werden, wozu ein Drehantrieb 3 vorgesehen ist (vgl. US-A-4 903 717).

Der Drehantrieb 3 besteht aus einem Antriebsmotor 4, dessen Abtriebsritzel 5 über einen Zahnriemen 6 mit einem auf der Trage-Welle 2 festgelegten Zahnrad 7 gekuppelt ist.

Um die hohle Trage-Welle 2 mit unter Druck stehendem Gas zu beaufschlagen, ist ihr unteres Ende in einem topfförmigen Körper 8 aufgenommen, an den eine Druckgasleitung 9 für das Zuführen von Gas (beispielsweise Stickstoff) angeschlossen ist, und der gegenüber dem unteren Ende der Trage-Welle 2 durch eine Labyrinthdichtung 10 abgedichtet ist.

Der Träger 1 besteht aus einem Grundkörper 20, der etwa topfförmig ausgebildet ist, aus einem ringförmigen Körper 21 und aus einem mittleren Körper 22, der im wesentlichen plattenförmig ausgebildet ist.

Der ringförmige Körper 21 sitzt über eine Ringrippe 23 an seinem Außenumfang auf dem Außenrand des topfförmigen Körpers 20 auf. Weiters ist der ringförmige Körper 21 über z.B. kreisbogenförmige Vorsprünge 24 an einer Fläche 25 des Grundkörpers 20 abgestützt.

Der mittlere Körper 22 weist eine Schulter 26 auf, die auf einer Stufe 27 des ringförmigen Körpers 21 aufliegt.

Der mittlere Körper 22 wird durch mehrere Spannschrauben 30 am Grundkörper 20 befestigt. Der ringförmige Körper 21 wird zwischen dem Grundkörper 20 und dem mittleren Körper 22 geklemmt.

Zwischen dem Grundkörper 20 und dem mittleren Körper 22 ist ein Raum 31 vorgesehen, der nach unten von der Fläche 25 des Grundkörpers 20 und nach oben von der Fläche 32 des mittleren Körpers 22 begrenzt wird. Von diesem Raum 31 geht ein spalt-förmiger Raum 33 aus, der von einander zugekehrten Flächen 34 und 35 des Grundkörpers 20 bzw. des ringförmigen Körpers 21 begrenzt wird.

Im Raum 31 und im spaltförmigen Raum 33 ist ein Zahnkranz 40 aufgenommen, der mit dem oberen Ende 41 der Trage-Welle 2 gekuppelt ist und der mit seiner radial außen liegenden Zahnung 42 mit Zahnrädern 43 an Wellen 44, die in Bohrungen im ringförmigen Körper 21 verdrehbar aufgenommen sind, kämmt. Jede Welle 44 trägt eine zu ihrer Drehachse exzentrisch angeordnete Nocke 45. Durch Verdrehen der Wellen 44 mit Hilfe des Zahnkranzes 40 kann der radiale Abstand der Nocken 45 von der Drehachse 11 des Trägers 1 verändert werden. Die Nocken 45 dienen als Anschläge zum seitlichen Abstützen eines am Träger 1 gehaltenen (nicht gezeigten) scheibenförmigen Gegenstandes (z.B. Siliziumwafer).

Der Zahnkranz 40 wird durch Gleitböcke 46, die im Grundkörper 20 ringsherum verteilt eingesetzt sind, abgestützt und geführt. Diese Gleitböcke 46 bestehen beispielsweise aus Teflon.

Es ist noch zu erwähnen, daß im Zahnkranz 40 nicht gezeigte Aussparungen vorgesehen sind, durch welche die Vorsprünge 24 des ringförmigen Körpers 21 und die Spannschrauben 30 ragen. Die Aussparungen sind so bemessen, daß der Zahnkranz 40 gegenüber dem ringförmigen Körper 21 und damit dem Träger 1 so weit verdreht werden kann, daß die Nocken 45 im gewünschten Ausmaß verstellt werden können.

Beim radialen Verdrehen der Nocken 45 durch Verstellen der Wellen 44 wird der Grundkörper 20 durch eine nicht näher gezeigte Bremsvorrichtung, die beispielsweise so wie in der US-A-4 903 717 beschrieben, nämlich als Schlauchbremse, ausgebildet sein kann, gebremst und die Trage-Welle 2 gegenüber dem Träger 1 verdreht. Durch diese Relativbewegung zwischen dem Träger 1 und seiner Tragewelle 2 werden auch die Wellen 44 der Nocken 45 verdreht.

Anstelle der aus der US-A-4 903 717 bekannten Schlauchbremse kann dem Grundkörper 20 auch eine Backenbremse zugeordnet sein.

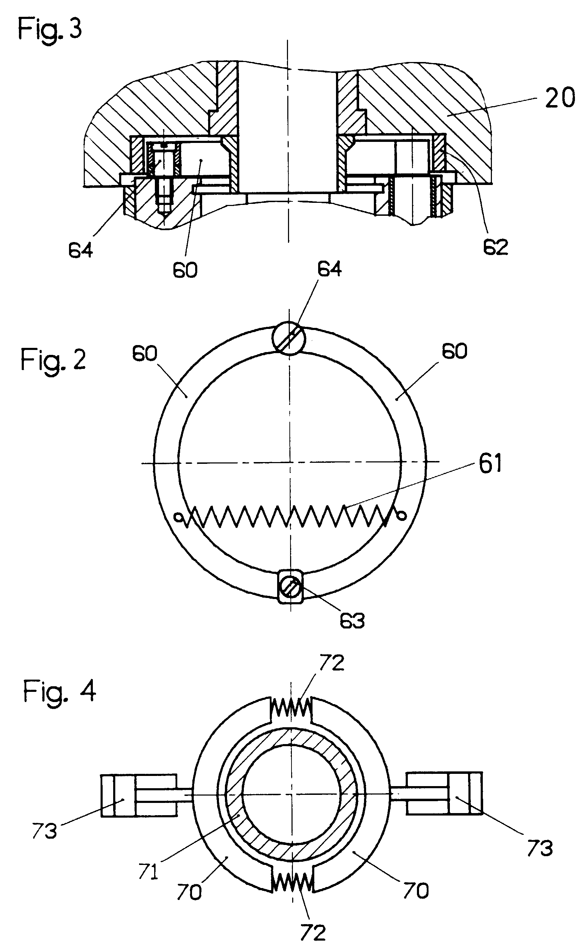

Für Träger 1 mit kleinerem Durchmesser (z.B. 8 Zoll) kann eine Backenbremse gemäß Fig. 2 und 3 vorgesehen sein. Die beiden etwa halbkreisförmigen Backen 60, die um eine ortsfeste Achse 64 verschwenkbar gelagert sind, werden von wenigstens einem Exzenter 63, der z.B. von einem pneumatischen Zylinder (nicht gezeigt) verstellt werden kann, nach außen gegen die Innenfläche eines ringförmigen Einsatzes 62 im Grundkörper 20 gedrückt, wenn dieser zu bremsen ist. Zum Lüften der Bremsbacken 60 ist wenigstens eine Zugfeder 61 vorgesehen, welche die Bremsbacken 60 radial nach innen vom ringförmigen Einsatz 62 des Grundkörpers 20 wegzieht.

Für größere Träger 1 wird eine Bremse (Fig. 4) bevorzugt, deren Backen 70 um einen Ansatz 71 des Grundkörpers 20 herum angeordnet sind. Die Backen 70 werden von zwei Druckfedern 72 gelüftet, d.h. vom Ansatz 71 abgehoben. Zum Bremsen sind zwei pneumatische Zylinder 73 vorgesehen, welche die Backen 71 entgegen der Wirkung der Federn 72 an den Ansatz 71 pressen.

Im mittleren Körper 22 des Trägers 1 ist ein Sackloch 50 vorgesehen, in dem die Trage-Welle 2 mit ihrem oberen Ende, wo die Bohrung 51 in der Trage-Welle 2 ausmündet, aufgenommen ist. Das obere Ende der Trage-Welle 2 wird gegenüber dem mittleren Körper 22 durch eine Dichtung 52 abgedichtet. Das aus der Bohrung 51 in der Trage-Welle 2 austretende und in den vom Sackloch 50 gebildeten Raum eintretende Gas strömt über mehrere radiale Bohrungen 53 in einen ringförmigen Raum 54 und aus diesem zur Düse 12, durch die sie aus dem Träger 1 austritt.

Der ringförmige Raum 54 wird von einander zugekehrten Flächen 55 und 56 des mittleren Körpers 22 bzw. des ringförmigen Körpers 21 begrenzt.

Es ist ersichtlich, daß der Raum 31 und der spaltförmige Raum 33, in dem der Drehantrieb für die Exzenternocken 45 aufgenommen ist, von dem Strömungsweg des Druckgases durch den Träger (Sackloch 50, Bohrungen 53, ringförmiger Raum 54) bis zur Düse 12 getrennt und abgedichtet (Dichtung 52) ist.

Die Benutzung des erfindungsgemäßen Trägers beim Behandeln von scheibenförmigen Gegenständen mit einer Behandlungsflüssigkeit, insbesondere beim Ätzen von Siliziumscheiben, erfolgt so, wie dies in der US-A-4 903 717 beschrieben ist, wobei der scheibenförmige Gegenstand von dem im aus der Düse 12 austretenden Gas aufgrund des aerodynamischen Paradoxons (Bernoulli-Prinzip) entstehenden Unterdruck zwischen dem scheibenförmigen Gegenstand und der ihm zugekehrten Fläche des Trägers 1 in einem Gleichgewichtszustand frei schwebend und dennoch so sicher festgehalten wird, daß er mit einer Behandlungsflüssigkeit behandelt werden kann.

Zusammenfassend kann der Träger beispielsweise wie folgt dargestellt werden:

An einem Träger 1 für scheibenförmige Gegenstände, der nach dem Bernoulli-Prinzip mit aus einer ringförmigen Düse 12 in der dem Gegenstand zugekehrten Fläche des Trägers 1 austretendem Druckgas arbeitet, sind rings um die ringförmige Düse 12 Nocken 45 als seitliche Anschläge für den scheibenförmigen Gegenstand vorgesehen. Die Nocken 45 sind exzentrisch an im Träger 1 verdrehbaren Wellen 44 angeordnet. Die Wellen 44 können mit Hilfe eines im Träger 1 aufgenommenen Zahnkranzes 40 zum radialen Verstellen der Nocken 45 verdreht werden. Der Raum 31, 33, in dem der Zahnkranz 40 aufgenommen ist, ist gegenüber dem Raum 50, 53, 54, durch den das Druckgas zur Düse 12 strömt, getrennt und abgedichtet. So wird verhindert, daß die Strömung des Gases durch den Verstellmechanismus für die Nocken 45 beeinträchtigt wird und daß vom Gas Abrieb mitgeführt und aus der Düse 12 gegen den zu behandelnden Gegenstand geblasen wird.

## Patentansprüche

1. Träger (1) nach dem Bernoulliprinzip für scheibenförmige Gegenstände, mit wenigstens einer im Umfangsbereich des Trägers (1) angeordneten Düse (12) in der dem Gegenstand zugekehrten Fläche des Trägers (1), der zum Ausbilden eines Gaspolsters zwischen dem Träger (1) und dem scheibenförmigen Gegenstandes Druckgas zugeführt wird, und mit an der dem Gegenstand zugekehrten Fläche des Trägers (1) im Umfangsbereich desselben angeordneten Anschlägen zum seitlichen Abstützen des scheibenförmigen Gegenstandes, die von Nocken (45) gebildet sind, die auf im Träger (1) drehbar gelagerten Wellen (44) zu deren Drehachsen exzentrisch angeordnet sind, wobei die Wellen (44) Ritzel (43) tragen, die mit einem im Träger (1) in einem Raum desselben um dessen Mittelachse (11) verdrehbar gelagerten Zahnkranz (40) kämmen, wobei der Zahnkranz (40) mit der Trage-Welle (2), an deren einem Ende der Träger (1) vorgesehen ist, gekuppelt ist, wobei durch die hohl ausgebildete Trage-Welle (2) das Druckgas über einen Raum im Träger (1) zur Düse (12) strömt, wobei zum Drehen des Trägers (1) an der Trage-Welle (2) im Abstand über ihrem dem Träger (1) gegenüberliegenden Ende ein Drehantrieb (3) angreift, wobei dem Träger (1) eine Bremse zugeordnet ist und wobei der Träger (1) aus einem Grundkörper (20), der auf der Trage-Welle (2) sitzt, einem ringförmigen Körper (21), in dem die Wellen (44) der Nocken (45) verdrehbar gelagert sind, und einem mittleren Körper (22), der zusammen mit dem ringförmigen Körper (21) an seinem Außenrand die Düse (12) definiert, besteht, dadurch gekennzeichnet, daß der Raum, über den der Düse (12) Druckgas zugeführt wird, von einem Sackloch (50) in der Mitte des mittleren Körpers (22), in den das freie Ende der Trage-Welle (2) eingreift, von zwei oder mehreren von diesem Sackloch (50) radial nach außen führenden Kanälen (53) im mittleren Körper (22) und von einem zwischen dem ringförmigen Körper (21) und dem mittleren Körper (22) vorgesehenen ringförmigen Raum (54) gebildet ist, daß der Raum (31), in dem der Zahnkranz (40) zum Betätigen der Nocken (45) aufgenommen ist, von einander zugekehrten Flächen (25, 32) des Grundkörpers (20) und des mittleren Körpers (21) und radial zur Mitte hin von der Trage-Welle (2) begrenzt ist und daß der Zahnkranz (40) sich radial außerhalb dieses Raumes (31) in einen spaltförmigen Raum (33) zwischen dem Grundkörper (20) und dem ringförmigen Körper (21) erstreckt, so daß der Raum (50, 53, 54), der zur Düse (12) führt, ein von dem Raum (31, 33), in dem der Zahnkranz (40) aufgenommen ist, getrennter Raum ist.

2. Träger nach Anspruch 1, dadurch gekennzeichnet, daß der den Zahnkranz (40) aufnehmende Raum (31, 33) durch eine Dichtung (52) von dem zur Düse (12) führenden, mit Druckgas beaufschlagten Raum (50, 53, 54) getrennt und nicht mit Druckgas beaufschlagt ist.

3. Träger nach Anspruch 1 oder 2, dadurch gekennzeichnet, daß er ein Träger (1) für Siliziumscheiben während des Ätzens derselben ist.

4. Träger nach einem der Ansprüche 1 bis 3, dadurch gekennzeichnet, daß die im Umfangsbereich des Trägers (1) angeordnete Düse (12) ringförmig ist.

5. Träger nach einem der Ansprüche 1 bis 4, dadurch gekennzeichnet, daß die dem Gegenstand zugekehrte Fläche des Trägers (1) kreisrund ist.

6. Träger nach einem der Ansprüche 1 bis 5, dadurch gekennzeichnet, daß der Drehantrieb (3) für den Träger (1) ein Zahnrad-Zahnriemengetriebe (5, 6, 7) ist.

7. Träger nach einem der Ansprüche 1 bis 6, dadurch gekennzeichnet, daß der ringförmige Körper (21) eine zum mittleren Körper (22) hin weisende Stufe (27) aufweist, gegen die eine Schulter (26) des mittleren Körpers (22) anliegt, und daß der mittlere Körper (22) mit dem Grundkörper (20) verbunden ist und den ringförmigen Körper (21) gegen den Grundkörper (20) hält.

8. Träger nach Anspruch 7, dadurch gekennzeichnet, daß im Grundkörper (20) mehrere Gleitblöcke (46), zum Führen des Zahnkranzes (40) vorgesehen sind.

9. Träger nach Anspruch 8, dadurch gekennzeichnet, daß die Gleitblöcke (46) aus Teflon bestehen.

10. Träger nach Anspruch 8 oder 9, dadurch gekennzeichnet, daß die Gleitblöcke (46) den Zahnkranz (40) in dessen von der Trage-Welle (2) entfernten Bereichen führen.

11. Träger nach einem der Ansprüche 2 bis 10, dadurch gekennzeichnet, daß die Dichtung (52) zwischen dem offenen Ende des Sackloches (50) im mittleren Körper (22) und dem freien Ende der Trage-Welle (2) angeordnet ist.

## Claims

1. Holder (1) according to the Bernoulli principle for disc-shaped articles, with at least one nozzle (12), disposed in the circumferential area of the holder (1), in the surface of the holder (1) facing the article to which compressed gas is supplied, to form a gas cushion between the holder (1) and the disc-shaped article, and with stops disposed in the circumferential area of the face of the holder (1) facing the article, for lateral support of the disc-shaped article, said stops being formed by cams (45), which are disposed on shafts (44) rotatably mounted in the holder (1) and eccentric to their axis of rotation, the shafts (44) carrying pinions (43), which mesh with a gear ring (40) mounted to rotate in a space of said holder about its central axis (11), the gear ring (40) being coupled to the carrier shaft (2), on one end of which the holder (1) is provided, the compressed gas flowing through the hollow carrier shaft (2) via a space in the holder (1) to the nozzle (12), a rotational drive (3) engaging in order to rotate the holder (1) on the carrier shaft (2) at a distance above its end lying opposite the carrier (1), there being associated with the holder (1) a brake, and the holder (1) consisting of a basic member (20), which sits on the carrier shaft (2), of an annular member (21), in which the shafts (44) of the cams (45) are mounted to rotate, and of a central member (22), which together with the annular member (21) defines the nozzle (12) at its outer edge, characterised in that the space through which compressed gas is supplied to the nozzle (12), is formed by a blind hole (50) in the centre of the central member (22), into which the free end of the support shaft (2) engages, by two or more ducts (53) leading outwards from this blind hole (50), in the central member (22), and of an annular space (54) provided between the annular member (21) and the central member (22), in that the space (31), in which the gear ring (40) is accommodated for actuating the cams (45), is defined by surfaces (25,32) facing one another of the basic member (20) and of the central member (22) and radially towards the centre by the carrier shaft (2), and in that the gear ring (40) extends radially outwith this space (31) into a slot-shaped space (33) between the basic member (30) and the annular member (21), so that the space (50,53,54) which leads to the nozzle (12) is a space separated from the space (31,32) in which the gear ring (40) is housed.

2. Holder according to claim 1, characterised in that the space (31,33) accommodating the gear ring (40) is separated by a seal (52) from the space (50,53,54) leading to the nozzle (12) and charged with compressed gas, and is not charged with compressed gas.

3. Holder according to claim 1 or 2, characterised in that it is a holder (1) for silicon discs during etching of the same.

4. Holder according to one of claims 1 to 3, characterised in that the nozzle (12) disposed in the circumferential area of the holder (1) is annular.

5. Holder according to one of claims 1 to 4, characterised in that the surface of the holder (1) facing the article is circular.

6. Holder according to one of claims 1 to 5, characterised in that the rotational drive (3) for the holder (1) is a gearwheel-synchronous belt drive (5,6,7).

7. Holder according to one of claims 1 to 6, characterised in that the annular member (21) has a step (27) facing the central member (22), and against which abuts a shoulder (26) of the central member (22), and in that the central member (22) is connected to the basic member (20), and holds the annular member (21) against the basic member (20).

8. Holder according to claim 7, characterised in that a plurality of slide blocks (46) are provided in the basic member (20) for guiding the gear ring (40).

9. Holder according to claim 8, characterised in that the slide blocks (46) consist of Teflon.

10. Holder according to claim 8 or 9, characterised in that the slide blocks (46) guide the gear ring (40) in its areas remote from the carrier shaft (2).

11. Holder according to one of claims 2 to 10, characterised in that the seal (52) is disposed between the open end of the blind hole (50) in the central member (22) and the free end of the carrier shaft (2).

## Revendications

1. Support (1) pour des objets en forme de disque suivant le principe de Bernoulli, comprenant au moins une buse (12) qui est disposée dans la zone périphérique du support (1) dans la face du support (1) tournée vers l'objet et à laquelle du gaz sous pression est amené en vue de l'établissement d'un coussin de gaz entre le support (1) et l'objet en forme de disque, et des butées disposées sur la face du support (1) tournée vers l'objet, dans la zone périphérique du support, pour servir d'appui latéral à l'objet en forme de disque, ces butées étant constituées par des cames (45) disposées sur des arbres (44) montés en rotation dans le support (1), en position excentrée par rapport aux axes de rotation de ces arbres, les arbres (44) portant des pignons (43) qui engrènent avec une couronne dentée (40) montée en rotation autour de l'axe central (11) du support (1), dans un espace de ce dernier, la couronne dentée (40) étant couplée avec l'arbre porteur (2) à l'une des extrémités duquel est prévu le support (1), le gaz sous pression s'écoulant, à travers l'arbre porteur (2) creux vers la buse (12) en passant par un espace dans le support (1), un système d'entraînement en rotation (3) agissant, en vue de la rotation du support (1), sur l'arbre porteur (2) à distance de l'extrémité de ce dernier opposée au support (1), un frein étant associé au support (1) et le support (1) étant composé d'un corps de base (20) qui est monté sur l'arbre porteur (2), d'un corps annulaire (21) dans lequel les arbres (44) des camas (45) sont montés en rotation, et d'un corps central (22) qui définit la buse (12) au niveau de son bord extérieur, conjointement avec le corps annulaire (21), caractérisé par le fait que l'espace par lequel le gaz sous pression est amené à la buse (12) est constitué par un trou borgne (50) au centre du corps central (22), trou dans lequel est engagée l'extrémité libre de l'arbre porteur (Z), par deux ou plus de deux canaux (53) ménagés dans le corps central (22) de manière à mener radialement vers l'extérieur depuis ledit trou borgne (50), et par un espace annulaire (54) prévu entre le corps annulaire (21) et le corps central (22), que l'espace (31) dans lequel est logée la couronne dentée (40) pour l'actionnement des cames (45) est délimité par les surfaces (25, 32), en regard l'une de l'autre, du corps de hase (20) et du corps central (21) et est délimité radialement vers le centre par l'arbre porteur (2) et que la couronne dentée (40) s'étendant radialement à l'extérieur de cet espace (31) dans un espace (33) en forme de fente entre le corps de base (20) et le corps annulaire (21), de sorte que l'espace (50, 53, 54) qui mène à la buse (12) est un espace séparé de l'espace (31, 33) dans lequel est logée la couronne dentée (40).

2. Support suivant la revendication 1, caractérisé par le fait que l'espace (31, 33) dans lequel est logée la couronne dentée (40) est séparé par un joint (52) de l'espace (50, 53, 54) menant à la buse (12), et n'est pas alimenté en gaz sous pression.

3. Support suivant la revendication 1 ou 2, caractérisé par le fait qu'il constitue un support (1) pour des disques de silicium pendant le gravage chimique de ces derniers.

4. Support suivant l'une des revendications 1 à 3, caractérisé par le fait que la buse (12) disposée dans la zone périphérique du support (1) est de forme annulaire.

5. Support suivant l'une des revendications 1 à 4, caractérisé par le fait que la face du support (1) tournée vers l'objet est circulaire.

6. Support suivant l'une des revendications 1 à 5, caractérisé par le fait que le système d'entraînement en rotation (3) pour le support (1) est une transmission à pignons et à courroie crantée.

7. Support suivant l'une des revendications 1 à 6, caractérisé par le fait que le corps annulaire (21) présente un gradin (27) qui est appliqué contre un épaulement (26) du corps central (22) et que le corps central (22) est relié au corps de base (20) et maintient le corps annulaire (21) contre le corps de base (20).

8. Support suivant la revendication 7, caractérisé par le fait que plusieurs patins de glissement (46) servant au guidage de la couronne dentée (40) sont prévus dans le support de base (20).

9. Support suivant la revendication 8, caractérisé par le fait que les patins de glissement (46) sont en Téflon

10. Support suivant la revendication 8 ou 9, caractérisé par le fait que les patins de glissement (46) guident la couronne dentée (40) dans les zones de cette dernière éloignées de l'arbre porteur (2).

11. Support suivant l'une des revendications 2 à 10, caractérisé par le fait que le joint (52) est disposé entre l'extrémité ouverte du trou borgne (50) dans le corps central (22) et l'extrémité libre de l'arbre porteur (2).
